(19) Europäisches Patentamt
European Patent Office
Office européen des brevets

(11) **EP 2 442 447 B1**

(12) **EUROPÄISCHE PATENTSCHRIFT**

(45) Veröffentlichungstag und Bekanntmachung des Hinweises auf die Patenterteilung:
**07.10.2015 Patentblatt 2015/41**

(21) Anmeldenummer: **11184795.0**

(22) Anmeldetag: **12.10.2011**

(51) Int Cl.:
**H03K 17/955** (2006.01)

(54) **Verfahren und Vorrichtung zum Bestimmen einer Kapazität und/oder einer Kapazitätsänderung eines kapazitiven Sensorelements**

Method and device for determining a capacity and/or a change in capacity of a capacitive sensor element

Procédé et dispositif de détermination d'une capacité et/ou d'une modification de capacité d'un élément de détection capacitif

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **14.10.2010 DE 102010042477**

(43) Veröffentlichungstag der Anmeldung:
**18.04.2012 Patentblatt 2012/16**

(73) Patentinhaber: **E.G.O. Elektro-Gerätebau GmbH 75038 Oberderdingen (DE)**

(72) Erfinder: **Roth, Bernhard 75038 Flehingen (DE)**

(74) Vertreter: **Patentanwälte Ruff, Wilhelm, Beier, Dauster & Partner Kronenstrasse 30 70174 Stuttgart (DE)**

(56) Entgegenhaltungen:
EP-A1- 1 339 025        FR-A1- 2 938 344
US-A1- 2007 046 299    US-A1- 2010 181 180

• **Thomas Perme ET AL: "AN1298: Capacitive Touch Using Only an ADC ("CVD")", , 7. Oktober 2009 (2009-10-07), XP055007357, Gefunden im Internet: URL:http://www.microchip.com/stellent/idcp lg?ldcService=SS_GET_PAGE&nodeId=1824&appn ote=en545264 [gefunden am 2011-09-16]**

**EP 2 442 447 B1**

## Beschreibung

### Anwendungsgebiet und Stand der Technik

Die Erfindung betrifft ein Verfahren und eine Vorrichtung zum Bestimmen einer Kapazität und/oder einer Kapazitätsänderung eines kapazitiven Sensorelements.

Die US 2010/0181180 A1 zeigt ein Verfahren sowie eine Vorrichtung zum Bestimmen einer Kapazität bzw. einer Kapazitätsänderung eines kapazitiven Sensorelements, bei dem ein interner Kondensator eines Mikroprozessors zur Kapazitätsmessung verwendet wird. Hierbei wird zunächst der interne Kondensator aufgeladen und das kapazitive Sensorelement entladen. Anschließend werden der interne Kondensator und das kapazitive Sensorelement miteinander verbunden, wobei die sich am internen Kondensator einstellende Spannung zum Bestimmen der Kapazität und/oder der Kapazitätsänderung ausgewertet wird. Alternativ wird zunächst der interne Kondensator entladen und das kapazitive Sensorelement aufgeladen.

Die FR 2 938 344 A1 zeigt ein Verfahren und eine Vorrichtung zur Kapazitätsmessung, bei dem ein Ladungstransfer zunächst von einem kapazitiven Sensorelement auf einen Betriebskondensator und im Anschluss daran ein Ladungstransfer von einem Mittelwertkondensator auf den Betriebskondensator erfolgt.

### Aufgabe und Lösung

Der Erfindung liegt die Aufgabe zugrunde, ein Verfahren und eine Vorrichtung zum Bestimmen einer Kapazität und/oder einer Kapazitätsänderung eines kapazitiven Sensorelements zur Verfügung zu stellen, welche eine zuverlässige Bestimmung der Kapazität bzw. der Kapazitätsänderung ermöglichen.

Die Erfindung löst diese Aufgabe durch ein Verfahren nach Anspruch 1 sowie eine Vorrichtung nach Anspruch 7.

Bevorzugte Ausführungsformen sind Gegenstand der Unteransprüche, deren Wortlaut hiermit durch Bezugnahme zum Inhalt der Beschreibung gemacht wird.

Das Verfahren zum Bestimmen einer Kapazität und/oder einer Kapazitätsänderung eines kapazitiven Sensorelements, d.h. eines Kondensators mit unbekannter Kapazität, dessen Kapazität sich beispielsweise berührungsabhängig verändert, umfasst die Schritte: a) Entladen eines Mittelwertkondensators mit bekannter oder unbekannter Kapazität; und entweder b1) Entladen des kapazitiven Sensorelements und c1) Laden eines Betriebskondensators mit bekannter oder unbekannter Kapazität auf eine bekannte oder unbekannte, jedoch im wesentlichen zeitlich konstante Ladespannung oder b2) Entladen des Betriebskondensators und c2) Laden des kapazitiven Sensorelements auf die Ladespannung, d) Verbinden des Betriebskondensators mit dem kapazitiven Sensorelement, e) Verbinden des Betriebskondensators mit dem Mittelwertkondensator, wobei zuvor selbstverständlich der Betriebskondensator von dem kapazitiven Sensorelement getrennt wird und anschließend vor einer erneuten Ausführung des Schritts b1) bzw. b2) der Betriebskondensator von dem Mittelwertkondensator getrennt wird, und f) Auswerten einer sich am Betriebskondensator oder am Mittelwertkondensator einstellenden Spannung zum Bestimmen der Kapazität und/oder der Kapazitätsänderung. Die oben beschriebenen Schritte bilden bevorzugt einen einzelnen Messzyklus, wobei der Messzyklus zur Bestimmung weiterer Messwerte bevorzugt zyklisch wiederholt wird. Die genannten Schritte werden bevorzugt nacheinander, in der angegebenen Reihenfolge ausgeführt. Bei unbekannter Ladespannung und unbekannter Kapazität des Referenz- und/oder Mittelwertkondensators kann beispielsweise die sich am Betriebskondensator oder am Mittelwertkondensator einstellende Spannung hinsichtlich einer Änderung überwacht werden, indem die aktuell gemessene Spannung mit einer Spannung eines vorhergehenden Messzyklus oder mehrerer vorhergehender Messzyklen verglichen wird. Bei bekannter Spannung und bekannten Kapazitäten lässt sich die Kapazität des Sensorelements beispielsweise rechnerisch anhand der sich einstellenden Spannung bestimmen.

Vor dem Schritt f) werden die Schritte b1) und c1) bzw. b2) und c2) bis e) eine vorgegebene, insbesondere zeitlich konstante, Anzahl Male wiederholt, beispielsweise fünf bis fünfzehn Mal, wobei im Anschluss an die Wiederholung die sich am Betriebskondensator oder am Mittelwertkondensator einstellende Spannung zum Bestimmen der Kapazität und/oder der Kapazitätsänderung ausgewertet wird. Alternativ werden die Schritte b1) und c1) bzw. b2) und c2) bis f) so lange wiederholt, bis sich in Schritt f) bei der Auswertung der sich am Betriebskondensator oder am Mittelwertkondensator einstellenden Spannung eine vorgegebene Schwellenspannung am Betriebskondensator oder am Mittelwertkondensator einstellt, wobei zum Bestimmen der Kapazität und/oder der Kapazitätsänderung zusätzlich eine Anzahl der Wiederholungen ausgewertet wird. Aus der benötigten Anzahl an Wiederholungen in Verbindung mit der vorgegebenen Spannung können die Kapazität und/oder die Kapazitätsänderung bestimmt werden.

In einer Weiterbildung ist die Ladespannung bekannt. Bevorzugt ist/sind die Kapazität des Betriebskondensators und/oder die Kapazität des Mittelwertkondensators bekannt.

In einer Weiterbildung wird das Verfahren mittels eines Mikroprozessors durchgeführt, wobei der Mikroprozessor umfasst: einen internen Kondensator, der den Betriebskondensator bildet, einen A/D-Wandler, der mit dem internen Kondensator verbunden ist, einen ersten, einen zweiten und einen dritten Port, die jeweils als Eingang oder als Ausgang konfigurierbar sind, wobei das kapazitive Sensorelement mit dem zweiten Port verbunden ist und der Mittelwertkondensator mit dem dritten Port verbunden ist, und einen Multiplexer, der eingangsseitig mit den Ports verbunden ist und der ausgangsseitig mit dem internen Kondensator verbunden ist und der einen der Ports mit dem internen Kondensator verbindet. Das Verfahren umfasst weiter folgende Schritte, die nacheinander durchgeführt werden: g) Konfigurieren des dritten Ports als Ausgang und Ausgeben eines Low-Signals am dritten Port, h) Konfigurieren des dritten Ports als Eingang, i) Konfigurieren des ersten Ports als Ausgang und Ausgeben eines High-Signals am ersten Port, j) Konfigurieren des zweiten Ports als Ausgang und Ausgeben eines Low-Signals am zweiten Port, k) Konfigurieren des zweiten Ports als Eingang, l) Setzen des Multiplexers derart, dass der interne Kondensator mit dem ersten Port verbunden ist, m) Setzen des Multiplexers derart, dass der interne Kondensator mit dem zweiten Port verbunden ist, n) Setzen des Multiplexers derart, dass der interne Kondensator mit dem dritten Port verbunden ist, o) Digitalisieren der am internen Kondensator anstehenden Spannung mittels des A/D-Wandlers in einen digitalen Spannungswert und p) Auswerten des digitalisierten Spannungswerts zum Bestimmen der Kapazität und/oder der Kapazitätsänderung.

Bevorzugt werden vor dem Schritt o) die Schritte j) bis n) eine vorgegebene Anzahl Male wiederholt. Alternativ werden die Schritte j) bis p) so lange wiederholt, bis sich in Schritt p) ein vorgegebener digitalisierter Schwellenspannungswert einstellt, wobei zum Bestimmen der Kapazität und/oder der Kapazitätsänderung zusätzlich eine Anzahl der Wiederholungen ausgewertet wird.

Die Vorrichtung zum Bestimmen einer Kapazität und/oder einer Kapazitätsänderung eines kapazitiven Sensorelements ist zur Durchführung des oben genannten Verfahrens ausgebildet und umfasst: einen Mittelwertkondensator, einen Betriebskondensator, Mittel zum Entladen des Mittelwertkondensators, Mittel zum Entladen des kapazitiven Sensorelements und/oder Laden des kapazitiven Sensorelements auf eine Ladespannung, Mittel zum Entladen des Betriebskondensators und/oder Laden des Betriebskondensators auf die Ladespannung, Mittel zum Verbinden des Betriebskondensators mit dem kapazitiven Sensorelement, Mittel zum Verbinden des Betriebskondensators mit dem Mittelwertkondensator und Mittel zum Auswerten einer sich am Betriebskondensator oder am Mittelwertkondensator einstellenden Spannung zum Bestimmen der Kapazität und/oder der Kapazitätsänderung.

In einer Weiterbildung umfasst die Vorrichtung einen Mikroprozessor mit einem internen Kondensator, der den Betriebskondensator bildet, einem A/D-Wandler, der mit dem internen Kondensator verbunden ist, einem ersten, einem zweiten und einem dritten Port, die jeweils als Eingang oder als Ausgang konfigurierbar sind, wobei das kapazitive Sensorelement mit dem zweiten Port verbunden ist und der Mittelwertkondensator mit dem dritten Port verbunden ist, einem Multiplexer, der eingangsseitig mit den Ports verbunden ist und der ausgangsseitig mit dem internen Kondensator verbunden ist und der einen der Ports mit dem internen Kondensator verbindet, und einem Programmspeicher zum Speichern von Programmcode, bei dessen Ablauf das Verfahren ausgeführt wird.

## Kurzbeschreibung der Zeichnung

Vorteilhafte Ausführungsformen der Erfindung sind in den Zeichnungen schematisch dargestellt und werden nachfolgend beschrieben. Hierbei zeigt:

Fig. 1 ein Blockdiagramm einer ersten Ausführungsform einer Vor-richtung zum Bestimmen einer Kapazität und/oder einer Kapazitätsänderung eines kapazitiven Sensorelements und

Fig. 2 ein Blockdiagramm einer weiteren Ausführungsform einer Vorrichtung zum Bestimmen einer Kapazität und/oder einer Kapazitätsänderung eines kapazitiven Sensorelements.

## Detaillierte Beschreibung der Ausführungsbeispiele

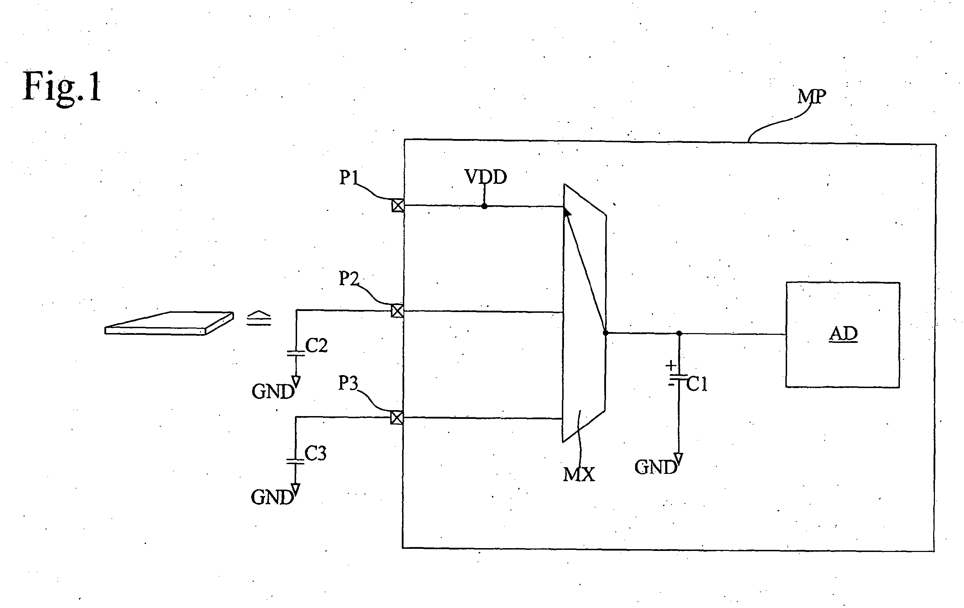

Fig. 1 zeigt schematisch ein Blockdiagramm einer ersten Ausführungsform einer Vorrichtung zum Bestimmen einer Kapazität und/oder einer Kapazitätsänderung eines kapazitiven Sensorelements C2, beispielsweise in Form einer kapazitiven Taste, deren Kapazität sich berührungsabhängig verändert. Das kapazitive Sensorelement C2 ist mittels seines elektrischen Ersatzschaltbilds dargestellt.

Die Vorrichtung umfasst einen Mikroprozessor MP mit einem internen Kondensator C1 bekannter Kapazität, der einen Betriebskondensator bildet, einen A/D-Wandler AD, der mit dem Betriebskondensator verbunden ist, einem ersten, einem zweiten und einem dritten Port P1, P2 und P3, die jeweils als Eingang oder als Ausgang konfigurierbar sind, wobei das kapazitive Sensorelement C2 mit dem zweiten Port P2 verbunden ist und der Mittelwertkondensator C3 mit dem dritten Port P3 verbunden ist, einem Multiplexer MX, der eingangsseitig mit den Ports P1 bis P3 verbunden ist und der ausgangsseitig mit dem Betriebskondensator C1 verbunden ist und der einen der Ports mit dem internen Kondensator verbindet, und einem nicht näher dargestellten Programmspeicher zum Speichern von Programmcode, bei dessen Ablauf das erfindungsgemäße Verfahren ausgeführt wird.

Zum Bestimmen der Kapazität und/oder der Kapazitätsänderung des kapazitiven Sensorelements C2 werden folgende Schritte nacheinander ausgeführt:

Zunächst wird in einem Schritt 1) der erste Port P1 als Ausgang konfiguriert und ein High-Signal am ersten Port P1 ausgegeben, d.h. am Port P1 steht eine Versorgungsspannung VDD des Mikroprozessors MP an.

Dann wird in einem Schritt 2) der dritte Port P3 als Ausgang konfiguriert und ein Low-Signal am dritten Port P3 ausgegeben, wodurch der Mittelwertkondensator C3 am Beginn einer Messung entladen wird.

Anschließend wird in einem Schritt 3) der dritte Port P3 als Eingang konfiguriert, um ein sukzessives Aufladen des Mittelwertkondensator C3 zu ermöglichen.

Nun wird in einem Schritt 4) der zweite Port P2 als Ausgang konfiguriert und ein Low-Signal am zweiten Port P2 ausgegeben, wodurch das kapazitive Sensorelement C2 entladen wird.

Anschließend wird in einem Schritt 5) der zweite Port P2 als Eingang konfiguriert, um ein Aufladen des Sensorelements C2 zu ermöglichen.

Nun wird in einem Schritt 6) der Multiplexer MX derart gesetzt, dass der interne Kondensator bzw. der Betriebskondensator C1 mit dem ersten Port P1 verbunden ist, wodurch der interne Kondensator C1 auf die Spannung VDD als Ladespannung aufgeladen wird.

Anschließend wird in einem Schritt 7) der Multiplexer MX derart gesetzt, dass der interne Kondensator C1 mit dem zweiten Port P2 und somit mit dem kapazitiven Sensorelement C2 verbunden ist. Es findet nun ein Ladungsausgleich zwischen den Kondensatoren C1 und C2 statt, d.h. der interne Kondensator C1 wird bis auf eine Restladung entladen.

Für die Spannung am internen Kondensator C1 nach Schritt 7) gilt:

$$US7 = C1 * VDD / (C1 + C2)$$

Nun wird in einem Schritt 8) der Multiplexer MX derart gesetzt, dass der interne Kondensator C1 mit dem dritten Port P3 und somit mit dem Mittelwertkondensator C3 verbunden ist, wodurch ein Teil der Restladung des internen Kondensators C1 auf den Mittelwertkondensator C3 umgeladen wird.

In einem Schritt 9) werden die Schritte 4 bis 8 nun n mal wiederholt, beispielsweise mit 4 < n < 25, wodurch sich in grober Näherung am internen Kondensator C1 und am Mittelwertkondensator C3 nach Schritt 8) folgende Spannung einstellt:

$$US8 = C1 * US7 * n / (C1 + C3)$$

Hierbei wird vereinfachend angenommen, dass die Aufladung des Mittelwertkondensator C3 im betrachteten Bereich linear erfolgt.

Die Spannung US8 wird in einem Schritt 10) mittels des A/D-Wandlers AD in einen digitalen Spannungswert umgewandelt und in einem Schritt 11) zum Bestimmen der Kapazität und/oder der Kapazitätsänderung des kapazitiven Sensorelements C2 ausgewertet.

Die genannten Schritte bilden einen Messzyklus, wobei die Schritte 2) bis 11) in aufeinanderfolgenden Messzyklen wiederholt werden.

Sind die Werte der Spannung VDD und die Kapazitätswerte der Kondensatoren C1 und C3 bekannt, kann die Kapazität des Kondensators C2 berechnet und somit ein Betätigungszustand des kapazitiven Sensorelements C2 bestimmt werden. Wenn die Werte nicht bekannt sind, kann durch Differenzbildung zwischen Messwerten aufeinanderfolgender Messzyklen auf eine Veränderung des Betätigungszustands geschlossen werden.

Anstatt der Wiederholung der Schritte 4 bis 8 im Schritt 9 eine vorgegebene, insbesondere konstante, Anzahl Male können alternativ die Schritte 4 bis 8 und 10 und 11 so lange wiederholt werden, bis sich ein vorgegebener digitalisierter Schwellenspannungswert einstellt, wobei zum Bestimmen der Kapazität und/oder der Kapazitätsänderung die Anzahl der Wiederholungen ausgewertet wird.

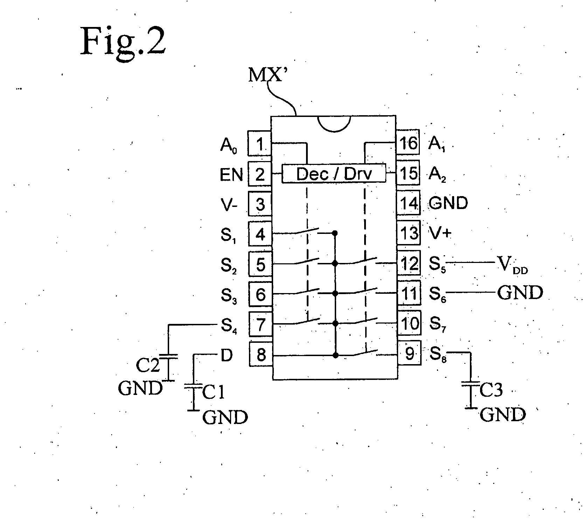

Fig. 2 zeigt ein Blockdiagramm einer weiteren Ausführungsform einer Vorrichtung zum Bestimmen einer Kapazität und/oder einer Kapazitätsänderung eines kapazitiven Sensorelements, bei der der interne Multiplexer MX und der interne Kondensator C1 als diskrete Bauelemente ausgeführt sind.

Ein Multiplexer MX', beispielsweise vom Typ DG508B, verbindet in Abhängigkeit vom Zustand von Signalen an Adresseingängen A0 bis A2 einen der Eingänge S1 bis S8 mit einem gemeinsamen Ausgang D. Die Adresseingänge A0 bis A3 sind mit Ports eines nicht gezeigten Mikroprozessors verbunden, der diese geeignet ansteuert. Der Mittelwertkondensator C3 ist mit dem Eingang S8 des Multiplexers MX' und einem nicht gezeigten Port des Mikroprozessors verbunden, wobei der Port als (analoger) Eingang und als Ausgang konfigurierbar ist. Am Eingang S5 liegt VDD an und am Eingang S6 liegt GND an.

An den Eingängen S1 bis S3 und S7 können noch weitere, nicht gezeigte kapazitive Sensorelemente angeschlossen sein.

Die in Fig. 2 gezeigte Schaltung kann beispielsweise wie folgt angesteuert bzw. betrieben werden;

Eine EN-Steuerleitung wird zunächst auf "1" gesetzt. Die EN-Steuerleitung kann gesetzt bleiben oder zwischen den einzelnen Verfahrensschritten kurz zurückgesetzt werden, um eindeutige Schaltzustände sicherzustellen.

Zum Aufladen des Betriebskondensators C1 auf VDD werden die Adresseingänge A0 bis A2 derart gesetzt, dass der dem Eingang S5 zugeordnete Schalter geschlossen wird.

Zum Ladungstransfer von C1 auf C2 werden die Adresseingänge A0 bis A2 derart gesetzt, dass der dem Eingang S4 zugeordnete Schalter geschlossen wird.

Zum Rest-Ladungstransfer von C1 auf C3 werden die Adresseingänge A0 bis A2 derart gesetzt, dass der dem Eingang S8 zugeordnete Schalter geschlossen wird.

Ein Entladen des kapazitiven Sensorelements C2 kann nun beispielsweise dadurch erfolgen, dass das kapazitive Sensorelement C2 zusätzlich noch mit einem Mikroprozessorport verbunden wird, der zum Entladen als Ausgang konfiguriert wird an dem ein Low-Signal ausgegeben wird. Alternativ kann ein schrittweises Entladen mittels des Betriebskondensators C1 erfolgen, der zunächst durch Verbinden mit GND mittels Schließen des dem Eingang S6 zugeordneten Schalters entladen und anschließend zum Entladen des kapazitiven Sensorelements C2 mit diesem verbunden wird.

Nach dem Entladen des kapazitiven Sensorelements C2 werden die oben genannten Schritte eine Anzahl Male wiederholt. Anschließend wird die Spannung am Kondensator C3 mittels eines AD-Wandlers des Mikroprozessors gemessen, die dann zur Kapazitätsbestimmung ausgewertet wird.

Anschließend kann der Mittelwertkondensator C3 durch Konfigurieren des zugehörigen Mikroprozessorports als Ausgang und Ausgeben eines Low-Signals entladen werden.

Die oben genannten Schritte können dann für sämtliche kapazitive Sensorelement wiederholt werden.

Bei den gezeigten Ausführungsformen wird vor einem Verbinden des kapazitiven Sensorelements mit dem Betriebskondensator das kapazitive Sensorelement entladen und der Betriebskondensator auf die Ladespannung geladen. Es versteht sich, dass alternativ auch zunächst das kapazitive Sensorelement auf die Ladespannung geladen und der Betriebskondensator entladen werden kann.

Die gezeigten Ausführungsformen ermöglichen ein zuverlässiges und störsicheres Bestimmen einer Kapazität und/oder einer Kapazitätsänderung eines kapazitiven Sensorelements.

**Patentansprüche**

1. Verfahren zum Bestimmen einer Kapazität und/oder einer Kapazitätsänderung eines kapazitiven Sensorelements (C2), mit den Schritten:

   a) Entladen eines Mittelwertkondensators (C3) und entweder

      b1) Entladen des kapazitiven Sensorelements und
      c1) Laden eines Betriebskondensators (C1) auf eine Ladespannung (VDD),
      oder
      b2) Entladen des Betriebskondensators und
      c2) Laden des kapazitiven Sensorelements auf die Ladespannung,

   d) Verbinden des Betriebskondensators mit dem kapazitiven Sensorelement und anschließendes Trennen des Betriebskondensators von dem kapazitiven Sensorelement,
   e) Verbinden des Betriebskondensators mit dem Mittelwertkondensator und
   f) Auswerten einer sich am Betriebskondensator oder am Mittelwertkondensator einstellenden Spannung zum Bestimmen der Kapazität und/oder der Kapazitätsänderung,
   **dadurch gekennzeichnet, dass**

      - in Schritt e) nach dem Verbinden des Betriebskondensators mit dem Mittelwertkondensator der Betriebskondensator von dem Mittelwertkondensator getrennt wird und vor dem Schritt f) die Schritte b1) und c1) bzw. b2) und c2) bis e) eine vorgegebene Anzahl Male wiederholt werden, oder
      - in Schritt e) nach dem Verbinden des Betriebskondensators mit dem Mittelwertkondensator der Betriebskondensator von dem Mittelwertkondensator getrennt wird und die Schritte b1) und c1) bzw. b2) und c2) bis f) so lange wiederholt werden, bis sich in Schritt f) eine vorgegebene Schwellenspannung am Betriebskondensator oder am Mittelwertkondensator einstellt, wobei zum Bestimmen der Kapazität und/oder der Kapazitätsänderung zusätzlich eine Anzahl der Wiederholungen ausgewertet wird.

2. Verfahren nach Anspruch 1, **dadurch gekennzeichnet, dass** die Ladespannung bekannt ist.

3. Verfahren nach Anspruch 1 oder 2, **dadurch gekennzeichnet, dass** die Kapazität des Betriebskondensators und/oder die Kapazität des Mittelwertkondensators bekannt ist/sind.

4. Verfahren nach einem der vorhergehenden Ansprüche, **dadurch gekennzeichnet, dass** das Verfahren mittels eines Mikroprozessors (MP) durchgeführt wird, wobei der Mikroprozessor umfasst:

      - einen internen Kondensator (C1), der den Betriebskondensator bildet,
      - einen A/D-Wandler (AD), der mit dem internen Kondensator verbunden ist,
      - einen ersten, einen zweiten und einen dritten Port (P1, P2, P3), die jeweils als Eingang oder als Ausgang konfigurierbar sind, wobei

         - das kapazitive Sensorelement mit dem zweiten Port verbunden ist und
         - der Mittelwertkondensator mit dem dritten Port verbunden ist, und

- einen Multiplexer (MX), der eingangsseitig mit den Ports verbunden ist und der ausgangsseitig mit dem internen Kondensator verbunden ist,
- wobei folgende Schritte durchgeführt werden:

g) Konfigurieren des ersten Ports als Ausgang und Ausgeben eines High-Signals am ersten Port,
h) Konfigurieren des dritten Ports als Ausgang und Ausgeben eines Low-Signals am dritten Port,
i) Konfigurieren des dritten Ports als Eingang,
j) Konfigurieren des zweiten Ports als Ausgang und Ausgeben eines Low-Signals am zweiten Port,
k) Konfigurieren des zweiten Ports als Eingang,
l) Setzen des Multiplexers derart, dass der interne Kondensator mit dem ersten Port verbunden ist,
m) Setzen des Multiplexers derart, dass der interne Kondensator mit dem zweiten Port verbunden ist,
n) Setzen des Multiplexers derart, dass der interne Kondensator mit dem dritten Port verbunden ist,
o) Digitalisieren der am internen Kondensator anstehenden Spannung mittels des A/D-Wandlers in einen digitalen Spannungswert und
p) Auswerten des digitalisierten Spannungswerts zum Bestimmen der Kapazität und/oder der Kapazitätsänderung.

5. Verfahren nach Anspruch 4, **dadurch gekennzeichnet, dass** vor dem Schritt o) die Schritte j) bis n) eine vorgegebene Anzahl Male wiederholt werden.

6. Verfahren nach Anspruch 4, **dadurch gekennzeichnet, dass** die Schritte j) bis p) so lange wiederholt werden, bis sich in Schritt p) ein vorgegebener digitalisierter Schwellenspannungswert einstellt, wobei zum Bestimmen der Kapazität und/oder der Kapazitätsänderung zusätzlich eine Anzahl der Wiederholungen ausgewertet wird.

7. Vorrichtung zum Bestimmen einer Kapazität und/oder einer Kapazitätsänderung eines kapazitiven Sensorelements (C2) zur Durchführung des Verfahrens nach einem der Ansprüche 1 bis 6, umfassend:

- einen Mittelwertkondensator (C3),
- einen Betriebskondensator (C1),

- Mittel (MP, P3) zum Entladen des Mittelwertkondensators,
- Mittel (MP, P2) zum Entladen des kapazitiven Sensorelements oder Laden des kapazitiven Sensorelements auf eine Ladespannung,
- Mittel (MP, P1, MX) zum Entladen des Betriebskondensators oder Laden des Betriebskondensators auf die Ladespannung,
- Mittel (MP, MX) zum Verbinden des Betriebskondensators mit dem kapazitiven Sensorelement,
- Mittel (MP, MX) zum Verbinden des Betriebskondensators mit dem Mittelwertkondensator und
- Mittel (MP, AD) zum Auswerten einer sich am Betriebskondensator oder am Mittelwertkondensator einstellenden Spannung zum Bestimmen der Kapazität und/oder der Kapazitätsänderung, und
- einen Mikroprozessor (MP), umfassend:
- einen internen Kondensator (C1), der den Betriebskondensator bildet,
- einen A/D-Wandler (AD), der mit dem internen Kondensator verbunden ist,
- einen ersten, einen zweiten und einen dritten Port (P1, P2, P3), die jeweils als Eingang oder als Ausgang konfigurierbar sind, wobei

- das kapazitive Sensorelement mit dem zweiten Port verbunden ist und
- der Mittelwertkondensator mit dem dritten Port verbunden ist,

- einen Multiplexer (MX), der eingangsseitig mit den Ports verbunden ist und der ausgangsseitig mit dem internen Kondensator verbunden ist, und
- einen Programmspeicher zum Speichern von Programmcode, bei dessen Ablauf das Verfahren nach einem der Ansprüche 1 bis 6 ausgeführt wird.

## Claims

1. Method for determining a capacitance and/or a change in capacitance of a capacitive sensor element (C2), including the steps of:

a) discharging an average value capacitor (C3), and
either

b1) discharging the capacitive sensor element and
c1) charging an operating capacitor (C1) to a charging voltage (VDD),
or

b2) discharging the operating capacitor and
c2) charging the capacitive sensor element to the charging voltage,

d) connecting the operating capacitor to the capacitive sensor element and subsequently separating the operating capacitor from the capacitive sensor element,
e) connecting the operating capacitor to the average value capacitor, and
f) evaluating a voltage established across the operating capacitor or across the average value capacitor in order to determine the capacitance and/or the change in capacitance, **characterized in that**

- in step e), after connecting the operating capacitor to the average value capacitor, the operating capacitor is separated from the average value capacitor and, before step f), the steps b1) and c1) or b2) and c2) to e) are repeated a predefined number of times, or
- in step e), after connecting the operating capacitor to the average value capacitor, the operating capacitor is separated from the average value capacitor, and the steps b1) and c1) or b2) and c2) to f) are repeated until a predefined threshold voltage is established across the operating capacitor or across the average value capacitor in step f), a number of repetitions being evaluated additionally in order to determine the capacitance and/or the change in capacitance.

2. Method according to Claim 1, **characterized in that** the charging voltage is known.

3. Method according to Claim 1 or 2, **characterized in that** the capacitance of the operating capacitor and/or the capacitance of the average value capacitor is/are known.

4. Method according to any one of the preceding Claims, **characterized in that** the method is carried out using a microprocessor (MP), the microprocessor comprising:

- an internal capacitor (C1) which forms the operating capacitor,
- an A/D converter (AD) which is connected to the internal capacitor,
- a first port, a second port and a third port (P1, P2, P3), each of which can be configured as an input or as an output,

- the capacitive sensor element being connected to the second port, and

- the average value capacitor being connected to the third port, and

- a multiplexer (MX) which is connected, on the input side, to the ports and is connected, on the output side, to the internal capacitor,
- the following steps being carried out:

g) configuring the first port as an output and outputting a high signal at the first port,
h) configuring the third port as an output and outputting a low signal at the third port,
i) configuring the third port as an input,
j) configuring the second port as an output and outputting a low signal at the second port,
k) configuring the second port as an input,
l) setting the multiplexer in such a manner that the internal capacitor is connected to the first port,
m) setting the multiplexer in such a manner that the internal capacitor is connected to the second port,
n) setting the multiplexer in such a manner that the internal capacitor is connected to the third port,
o) digitizing the voltage present across the internal capacitor into a digital voltage value using the A/D converter, and
p) evaluating the digitized voltage value in order to determine the capacitance and/or the change in capacitance.

5. Method according to Claim 4, **characterized in that** before step o), the steps j) to n) are repeated a predefined number of times.

6. Method according to Claim 4, **characterized in that** the steps j) to p) are repeated until a predefined digitized threshold voltage value is established in step p), a number of repetitions being evaluated additionally in order to determine the capacitance and/or the change in capacitance.

7. Device for determining a capacitance and/or a change in capacitance of a capacitive sensor element (C2) for carrying out the method according to any one of claims 1 to 6, comprising:

- an average value capacitor (C3),
- an operating capacitor (C1),
- means (MP, P3) for discharging the average value capacitor,
- means (MP, P2) for discharging the capacitive sensor element or charging the capacitive sensor element to a charging voltage,
- means (MP, P1, MX) for discharging the operating capacitor or charging the operating capacitor to a charging voltage,
- means (MP, MX) for connecting the operating capacitor to the capacitive sensor element,
- means (MP, MX) for connecting the operating capacitor to the average value capacitor, and
- means (MP, AD) for evaluating a voltage established across the operating capacitor or across the average value capacitor in order to determine the capacitance and/or the change in capacitance, and
- a microprocessor (MP), comprising:
- an internal capacitor (C1) which forms the operating capacitor,
- an A/D converter (AD) which is connected to the internal capacitor,
- a first port, a second port and a third port (P1, P2, P3), each of which can be configured as an input or as an output,

 - the capacitive sensor element being connected to the second port, and
 - the average value capacitor being connected to the third port,

- a multiplexer (MX) which is connected, on the input side, to the ports and is connected, on the output side, to the internal capacitor, and
- a program memory for storing program code, during the execution of which the method according to any one of Claims 1 to 6 is carried out.

**Revendications**

1. Procédé de détermination d'une capacité et/ou d'une variation de capacité d'un élément de détection capacitif (C2), comprenant les étapes suivantes :

 a) décharge d'un condensateur intermédiaire (C3) et
 soit

 b1) décharge de l'élément de détection capacitif et
 c1) charge d'un condensateur de service (C1) à une tension de charge (VDD),
 soit
 b2) décharge du condensateur de service et
 c2) charge de l'élément de détection capacitif à la tension de charge,

 d) connexion du condensateur de service avec l'élément de détection capacitif et ensuite déconnexion du condensateur de service de l'élément de détection capacitif,
 e) connexion du condensateur de service avec le condensateur intermédiaire et

f) interprétation d'une tension qui s'établit aux bornes du condensateur de service ou du condensateur intermédiaire en vue de déterminer la capacité et/ou la variation de capacité, **caractérisé en ce que**

 - dans l'étape e), après la connexion du condensateur de service avec le condensateur intermédiaire, le condensateur de service est déconnecté du condensateur intermédiaire et les étapes b1) et c1) ou b2) et c2) sont répétées un nombre prédéfini de fois avant l'étape f), ou
 - dans l'étape e), après la connexion du condensateur de service avec le condensateur intermédiaire, le condensateur de service est déconnecté du condensateur intermédiaire et les étapes b1) et c1) ou b2) et c2) sont répétées jusqu'à ce qu'une tension de seuil prédéfinie s'établisse à l'étape f) aux bornes du condensateur de service ou du condensateur intermédiaire, un certain nombre de répétitions étant en plus interprétées en vue de déterminer la capacité et/ou la variation de capacité.

2. Procédé selon la revendication 1, **caractérisé en ce que** la tension de charge est connue.

3. Procédé selon la revendication 1 ou 2, **caractérisé en ce que** la capacité du condensateur de service et/ou la capacité du condensateur intermédiaire et/sont connue(s).

4. Procédé selon l'une des revendications précédentes, **caractérisé en ce que** le procédé est mis en oeuvre par l'intermédiaire d'un microprocesseur (MP), le microprocesseur comprenant :

 - un condensateur interne (C1) qui forme le condensateur de service,
 - un convertisseur A/N (AD) qui est relié au condensateur interne,
 - un premier, un deuxième et un troisième ports (P1, P2, P3) qui peuvent respectivement être configurées en tant qu'entrée ou sortie,

 - l'élément de détection capacitif étant relié au deuxième port et
 - le condensateur intermédiaire étant relié au troisième port, et

 - un multiplexeur (MX) dont l'entrée est reliée aux ports et dont la sortie est reliée au condensateur interne,
 - les étapes suivantes étant exécutées :

 g) configuration du premier port en tant que sortie et délivrance d'un signal de niveau haut sur le premier port,

h) configuration du troisième port en tant que sortie et délivrance d'un signal de niveau bas sur le troisième port,

i) configuration du troisième port en tant qu'entrée,

j) configuration du deuxième port en tant que sortie et délivrance d'un signal de niveau bas sur le deuxième port,

k) configuration du deuxième port en tant qu'entrée,

l) paramétrage du multiplexeur de telle sorte que le condensateur interne est relié au premier port,

m) paramétrage du multiplexeur de telle sorte que le condensateur interne est relié au deuxième port,

n) paramétrage du multiplexeur de telle sorte que le condensateur interne est relié au troisième port,

o) numérisation de la tension présente aux bornes du condensateur interne par l'intermédiaire du convertisseur A/N en une valeur de tension numérique et

p) interprétation de la valeur de tension numérisée en vue de déterminer la capacité et/ou la variation de capacité.

5. Procédé selon la revendication 4, **caractérisé en ce que** les étapes j) à n) sont répétées un nombre prédéfini de fois avant l'étape o).

6. Procédé selon la revendication 4, **caractérisé en ce que** les étapes j) à p) sont répétées jusqu'à ce qu'une valeur de tension de seuil numérisée prédéfinie s'établisse à l'étape p), un certain nombre de répétitions étant en plus interprétées en vue de déterminer la capacité et/ou la variation de capacité.

7. Dispositif de détermination d'une capacité et/ou d'une variation de capacité d'un élément de détection capacitif (C2), destiné à mettre en oeuvre le procédé selon l'une des revendications 1 à 6, comprenant :

    - un condensateur intermédiaire (C3),
    - un condensateur de service (C1),
    - des moyens (MP, P3) servant à décharger le condensateur intermédiaire,
    - des moyens (MP, P2) servant à décharger l'élément de détection capacitif ou servant à charger l'élément de détection capacitif à une tension de charge,
    - des moyens (MP, P1, MX) servant à décharger le condensateur de service ou à charger le condensateur de service à la tension de charge,
    - des moyens (MP, MX) servant à connecter le condensateur de service avec l'élément de détection capacitif,
    - des moyens (MP, MX) servant à connecter le condensateur de service avec l'élément de détection intermédiaire et
    - des moyens (MP, AD) servant à interpréter une tension qui s'établit aux bornes du condensateur de service ou du condensateur intermédiaire en vue de déterminer la capacité et/ou la variation de capacité, et
    - un microprocesseur (MP) comprenant :
    - un condensateur interne (C1) qui forme le condensateur de service,
    - un convertisseur A/N (AD) qui est relié au condensateur interne,
    - un premier, un deuxième et un troisième ports (P1, P2, P3) qui peuvent respectivement être configurées en tant qu'entrée ou sortie,

        - l'élément de détection capacitif étant relié au deuxième port et
        - le condensateur intermédiaire étant relié au troisième port,

    - un multiplexeur (MX) dont l'entrée est reliée aux ports et dont la sortie est reliée au condensateur interne, et
    - une mémoire de programme servant à enregistrer un code de programme qui, lors de son exécution, met en oeuvre le procédé selon l'une des revendications 1 à 6.

# Fig.1

# Fig.2

**EP 2 442 447 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20100181180 A1
- FR 2938344 A1